# EUROPÄISCHE PATENTANMELDUNG

(11) **EP 2 192 824 A1**
(43) Veröffentlichungstag der Anmeldung: **02.06.2010**
(21) Anmeldenummer: 08020634.5
(22) Anmeldetag: 27.11.2008
(51) Int. Cl.: H05K 1/02

(54) **Leiterplatte mit einer Beschichtung aus einem elektromagnetische Strahlungen dämpfenden Material**

(71) Anmelder: Siemens Aktiengesellschaft, 80333 München (DE)
(72) Erfinder: Bunk, Jens-Andre, 91056 Erlangen (DE)

(57) **Zusammenfassung**

Die Erfindung betrifft eine Leiterplatte, wobei die Leiterplatte (1,1') elektrisch leitende Leiterbahnen aufweist, wobei die Leiterplatte (1,1') in mindestens einem Bereich (8a) der Leiterplatte (1,1') in dem mindestens eine Leiterbahn (4a) verläuft auf der Vorderseite (A) und/oder der Rückseite (B) der Leiterplatte (1,1') eine Beschichtung (5a) aus einem elektromagnetische Strahlungen dämpfenden Material aufweist, wobei das Material in dem Bereich (8a) auf die Oberfläche der Leiterplatte (1,1') ein- oder mehrschichtig aufgedruckt und/oder ein- oder mehrschichtig aufgespritzt ist. Weiterhin betrifft die Erfindung Verfahren zur Reduzierung von auf eine Leiterbahn (4a) einer Leiterplatte (1,1') einwirkende elektromagnetische Störeinstrahlungen und/oder von einer Leiterbahn (4a) einer Leiterplatte ausgesendete elektromagnetische Störausstrahlungen. Die Erfindung ermöglicht auf eine Leiterbahn (4a) einer Leiterplatte (1,1') einwirkende elektromagnetische Störeinstrahlungen und/oder von einer Leiterbahn (4a) einer Leiterplatte (1,1') ausgesendete elektromagnetische Störausstrahlungen zu reduzieren.

## Beschreibung

Die Erfindung betrifft eine Leiterplatte sowie Verfahren zur Reduzierung von auf eine Leiterbahn einer Leiterplatte einwirkende elektromagnetische Störeinstrahlungen und/oder von einer Leiterbahn einer Leiterplatte ausgesendete elektromagnetische Störausstrahlungen

Aufgrund der immer weitergehenden Erhöhung der Komplexität von elektrischen Leiterplatten und der Verringerung des für die Leiterplatte zugestandenen Einbauraums steigen auch die Anforderungen an die Robustheit der auf der Leiterplatte realisierten elektrischen Schaltungen gegenüber elektromagnetischen Störeinstrahlungen und insbesondere gegenüber elektromagnetischen Störeinstrahlungen im Hochfrequenzbereich. Gleichzeitig wird auch eine Verminderung von elektromagnetischen Störausstrahlungen, welche von den Leiterbahnen der Schaltungen selber ausgestrahlt werden, erwartet. Die elektromagnetischen Strahlungen liegen dabei in Form von elektromagnetischen Wellen vor.

Um elektromagnetische Störeinstrahlungen und/oder Störausstrahlungen, insbesondere im elektromagnetischen Hochfrequenzbereich, zu reduzieren, werden handelsüblich zahlreiche Maßnahmen eingesetzt. So wird unter anderem versucht, die Gehäusekonstruktion in der die Leiterplatte mit den elektrischen Schaltungen untergebracht ist, zu verbessern und/oder auf den Leiterplatten Filterelemente und/oder Filterschaltungen zu platzieren und/oder die Verlegung der Leiterbahnen auf der Leiterplatte und/oder im Falle von mehrlagigen Leiterplatten innerhalb der Leiterplatte zu optimieren.

Weiterhin ist es zur Reduzierung von elektromagnetische Störeinstrahlungen und/oder Störausstrahlungen auch bekannt sogenannte EMV-Folien/-Dichtungen/-Matten/-Federn an oder im Gehäuse oder teilweise an den Schaltungen zu platzieren und die zu- und abgehenden Kabel und Leitungen der Leiterplatte zu schirmen und an dem Gehäuse anzuschließen und das Gehäuse zu erden.

Üblicherweise werden heutzutage im Vorfeld im Allgemeinen die zu erwartenden hinsichtlich elektromagnetischer Ein- und/oder Ausstrahlung kritischen Stellen bestimmt und mit den oben genannten herkömmlichen Mitteln zu entschärfen versucht. Es ist aber insbesondere bei neuen Schaltungen und neuen Gerätekonstruktionen im Vorfeld nicht komplett jedes Risiko ausschließbar. Oftmals werden heutzutage ein oder mehrere Iterationsschritte benötigt, um ein optimales den Erfordernissen entsprechendes Gesamtprodukt zu erzielen. Wenn in Folge von unerwartenden Störeinstrahlungen und/oder Störausstahlungen ein Redesign der Leiterplatte notwendig ist, ist dies mit einem entsprechenden Kosten- und Zeitbedarf verbunden, was nachteilig ist.

Aus der DE 10 2004 028 603 ist ein Verfahren zur Beschichtung einer Seite einer Leiterplatte, eine beschichtete Leiterplatte sowie ein Beschichtungs-Material bekannt.

Aus der DE 103 43 362 ist ein Verfahren zur Herstellung einer Leiterplatte bekannt, bei dem eine mit einer ferritischen Dünnschicht versehenen Folie mit einem Trägermaterial der Leiterplatte und andern gegebenenfalls bereits auf das Trägermaterial aufgebrachte Schichten verpresst wird Bei der DE 103 43 362 müssen aber schon beim Herstellungsprozess der Leiterplatte selbst die für Störeinstrahlung und/oder Störausstrahlung kritischen Stellen bekannt sein. Treten zu einem späteren Zeitpunkt an nicht abgeschirmten Stellen Störeinstrahlung und/oder Störausstrahlungen auf, dann muss die komplette Leiterplatte neu hergestellt werden.

Es ist Aufgabe der Erfindung auf eine Leiterbahn einer Leiterplatte einwirkende elektromagnetische Störeinstrahlungen und/oder von einer Leiterbahn einer Leiterplatte ausgesendete elektromagnetische Störausstrahlungen zu reduzieren.

Diese Aufgabe wird gelöst durch eine Leiterplatte, wobei die Leiterplatte elektrisch leitende Leiterbahnen aufweist, wobei die Leiterplatte in mindestens einem Bereich der Leiterplatte in dem mindestens eine Leiterbahn verläuft auf der Vorderseite und/oder der Rückseite der Leiterplatte eine Beschichtung aus einem elektromagnetische Strahlungen dämpfenden Material aufweist, wobei das Material in dem Bereich auf die Oberfläche der Leiterplatte ein- oder mehrschichtig aufgedruckt und/oder ein- oder mehrschichtig aufgespritzt ist.

Weiterhin wird diese Aufgabe gelöst durch Verfahren zur Reduzierung von auf eine Leiterbahn einer Leiterplatte einwirkende elektromagnetische Störeinstrahlungen und/oder von einer Leiterbahn einer Leiterplatte ausgesendete elektromagnetische Störausstrahlungen, wobei auf die Leiterplatte in mindestens einem Bereich der Leiterplatte in dem mindestens eine Leiterbahn verläuft auf der Vorderseite und/oder der Rückseite der Leiterplatte eine Beschichtung aus einem elektromagnetische Strahlungen dämpfenden Material aufgebracht wird indem das Material in dem Bereich auf die Oberfläche der Leiterplatte ein- oder mehrschichtig aufgedruckt und/oder ein- oder mehrschichtig aufgespritzt wird.

Vorteilhafte Ausbildungen der Erfindung ergeben sich aus den abhängigen Ansprüchen.

Vorteilhafte Ausbildungen der Leiterplatte ergeben sich analog zur vorteilhaften Ausbildungen des Verfahrens und umgekehrt.

Es erweist sich als vorteilhaft, wenn das Material eisenhaltig und/oder ferrithaltig ist, da eisenhaltige und/oder ferrithaltige Materialien elektromagnetische Strahlungen stark dämpfen.

Ferner erweist es sich als vorteilhaft, wenn das Material nicht elektrisch leitend ist, da dann das Auftreten von vom Material bedingten elektrischen Kurzschlüssen auf der Leiterbahn zuverlässig vermieden werden können.

Ferner erweist es sich als vorteilhaft, wenn das Material auf der Vorderseite und/oder der Rückseite der Leiterplatte in dem Bereich einen direkten mechanischen Kontakt mit den Leiterbahnen aufweist, da dann eine besonders hohe Reduzierung von auf die Leiterbahn der Leiterplatte einwirkende elektromagnetische Störeinstrahlungen und/oder von der Leiterbahn der Leiterplatte ausgesendete elektromagnetische Störausstrahlungen ermöglicht wird.

Ferner erweist es sich als vorteilhaft, wenn das Material bis mindestens 200°C temperaturbeständig ist, da dann viele der üblichen Fertigungsverfahren und insbesondere Lötverfahren bei der Fertigung einer Baugruppe eingesetzt werden können, wenn das Aufbringen der Beschichtung vor dem Löten und/oder Einpressen der Bauelemente auf die Leiterplatte durchgeführt wird.

Weiterhin erweist es sich als vorteilhaft, wenn die Dicke der Beschichtung an eine gewünschte Dämpfungshöhe der elektromagnetischen Strahlungen angepasst ist. In Bereichen, in denen starke elektromagnetische Störeinstrahlungen und/oder Störausstrahlungen auftreten, kann somit das dämpfende Material besonders dick aufgebracht werden und somit eine sehr hohe Dämpfung erzielt werden, während in Bereichen mit z.B. mittlerer elektromagnetischer Strahlungsstärke die Dicke des auf die Oberfläche der Leiterplatte aufgebrachten dämpfenden Materials reduziert werden kann und somit Material gespart werden kann. Die durch die Beschichtung erzielte Dämpfungshöhe der elektromagnetischen Strahlungen kann somit gezielt durch die Dicke der Beschichtung beim Aufbringen der Beschichtung gesteuert werden.

Vorteilhafte Ausbildungen der Erfindung sind in der Zeichnung dargestellt und werden im Folgenden näher erläutert. Dabei zeigen:
- FIG 1: ein erstes Ausführungsbeispiel der erfindungsgemäßen Leiterplatte in Form einer Draufsicht auf die Leiterplatte,
- FIG 2: eine Schnittansicht der erfindungsgemäßen ersten Ausführungsform der Leiterplatte,
- FIG 3: eine Schnittansicht einer weiteren Ausführungsform der erfindungsgemäßen Leiterplatte und
- FIG 4: eine Schnittansicht einer weiteren Ausführungsform der erfindungsgemäßen Leiterplatte, deren Rückseite Leiterbahnen aufweist.
- FIG 5: eine Schnittansicht einer weiteren Ausführungsform der erfindungsgemäßen Leiterplatte, deren Rückseite Leiterbahnen aufweist.

Erfindungsgemäß wird durch einen vorzugsweise nachträglichen, d.h. nach Herstellung der Leiterplatte, vorzugsweise vor dem Bestücken der Leiterplatte mit Bauelementen stattfindenden Beschichtungsprozess gezielt in den dafür vorgesehenen kritischen Bereichen gezielt eine Beschichtung aus einem elektromagnetische Strahlungen dämpfenden Material auf die Oberfläche der Leiterplatte aufgebracht. Die Beschichtung kann dabei sowohl mittels eines Druckprozesses als auch mittels eines Spritzprozesses auf die Oberfläche der Leiterplatte aufgebracht werden. Durch das partielle, insbesondere nachträgliche Beschichten der Leiterplatte mit dem elektromagnetische Strahlungen dämpfenden Material kann die gewünschte Reduzierung von elektromagnetische Störeinstrahlungen und Störausstrahlungen mit geringem Zeit- und Kosteneinsatz erreicht werden. Selbstverständlich kann das erfindungsgemäße Verfahren aber auch bei der Herstellung der Leiterplatte, als quasi letzter Schritt der Herstellung durchgeführt werden und/oder nach Bestückung der Leiterplatte mit Bauelementen und/oder nach dem Löten der Bauelemente.

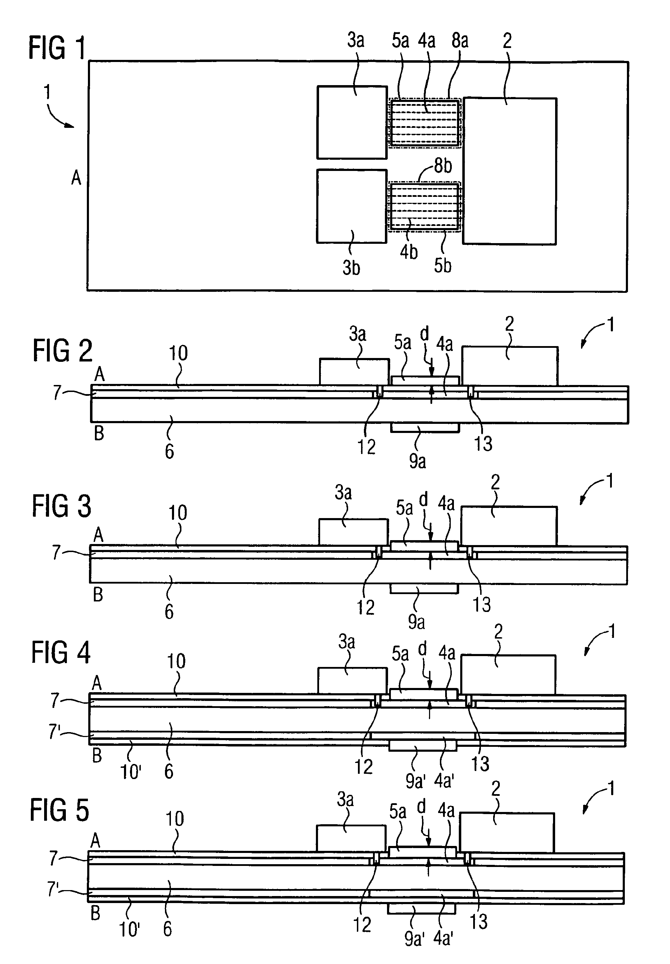

In FIG 1 ist in Form einer schematisierten Darstellung im Rahmen eines ersten Ausführungsbeispiels der Erfindung eine Draufsicht von oben auf die Vorderseite A einer erfindungsgemäßen Leiterplatte 1 dargestellt, wobei nur die zum Verständnis der Erfindung wesentlichen Elemente in FIG 1 dargestellt sind. Die Leiterplatte 1 ist mit einem Prozessor 2 und einem Speicher 3a und einem Speicher 3b bestückt. Zwischen dem Speicher 3a und dem Prozessor 2, sowie zwischen dem Speicher 3b und dem Prozessor 2 verlaufen gestrichelt dargestellte Leiterbahnen, welche elektrisch leitende Verbindungen zwischen dem Speicher 3a und dem Prozessor 2 und zwischen dem Speicher 3b und dem Prozessor 2 herstellen, wobei der Übersicht halber nur die Leiterbahnen 4a und 4b mit Bezugszeichen versehen sind. Da die elektrischen Signale, welche auf den Leiterbahnen 4a und 4b verlaufen, eine hohe Frequenz aufweisen (z.B. größer 100 MHz), kommt es zur Aussendung von elektromagnetischen Störausstrahlungen von den Leiterbahnen. Gleichzeitig wirken auf die Leiterbahnen elektromagnetische Störeinstrahlungen ein, die zu Fehlfunktionen des Prozessors 2, des Speichers 3 oder des Speichers 3b führen können. Die Bereiche 8a und 8b innerhalb derer die Leiterbahnen 4a und 4b verlaufen, stellen somit sogenannte kritische Bereiche dar, in denen elektromagnetische Störausstrahlungen auftreten und elektromagnetische Störeinstrahlungen zu Fehlfunktionen der auf der Leiterplatte angeordneten Schaltungen führen können. Falls solche Bereiche nicht schon aus der Erfahrung heraus bekannt sind, können sie z.B. mittels Simulation oder durch Messung ermittelt werden.

Erfindungsgemäß wird nun in dem Bereich 8a eine Beschichtung 5a und in dem Bereich 8b eine Beschichtung 5b aus einem elektromagnetische Strahlungen dämpfenden Material auf die Oberfläche der Leiterplatte aufgebracht in dem das Material in dem Bereich auf die Oberfläche der Leiterplatte ein- oder mehrschichtig aufgedruckt und/oder ein- oder mehrschichtig aufgespritzt wird. Die Beschichtung 5a deckt in dem Bereich 8a die zu dem Bereich 8a zugehörigen Leiterbahnen ab und die Beschichtung 5b deckt in dem Bereich 8b die zu dem Bereich 8b zugehörigen Leiterbahnen ab.

Das Material dämpft dabei elektromagnetische Strahlungen, insbesondere hochfrequente elektromagnetische Strahlungen (z.B. Frequenzen größer 100 MHz), in dem es elektromagnetische Strahlungen absorbiert und/oder reflektiert. Das Material liegt dabei vorzugsweise in flüssiger Form vor und ist vorzugsweise eisenhaltig und/oder ferrithaltig. Das Material kann solchermaßen z.B. in Form einer Flüssigkeit vorliegen, die eisenhaltige Partikel und/oder ferrithaltige Partikel aufweist. Die Flüssigkeit kann dabei z.B. als Klebstoff ausgebildet sein. Das Material ist dabei vorzugsweise nicht elektrisch leitend. Dies kann z.B. dadurch erreicht werden, dass die eisenhaltigen und/oder ferrithaltigen Partikel mit einer entsprechenden elektrisch nicht leitenden Schutzschicht versehen werden, wobei Ferrite im allgemeinen ohnehin nur eine sehr geringe elektrisch Leitfähigkeit aufweisen, so dass beim Einsatz von Ferriten eventuell auch auf eine Schutzschicht verzichtet werden kann.

In FIG 2 ist in Form einer schematisierten Darstellung eine Schnittansicht der Leiterplatte 1 dargestellt. Die Leiterplatte 1 weist eine Trägerschicht 6, die z.B. in Form einer Kunststoffschicht vorliegen kann, auf. Auf der Trägerschicht 6 ist eine Leiterbahnenschicht 7, die durch die Leiterbahnen gebildet wird, aufgebracht, wobei in der Darstellung gemäß FIG 2 die Leiterbahn 4a dargestellt ist. In diesen Zusammenhang sei an dieser Stelle darauf hingewiesen, dass es sich bei den in FIG 2 bis FIG 5 gezeigten Darstellungen jeweils um eine stark schematisierte Ansicht handelt, bei der die einzelnen Schichten als Rechtecke dargestellt sind und die Proportionen, Abmessungen und Verläufe der einzelnen dargestellten Schichten und Elemente nicht maßstabsgetreu sind. Weiterhin ist in FIG 2 bis FIG 4 auch nur die Leiterbahn 4a dargestellt, wobei der Übersichtlichkeit halber eventuell in der Leiterbahnenschicht 7 verlaufende weitere Leiterbahnen nicht dargestellt sind.

Die Leiterbahn 4a ist mit einer elektrisch nicht leitenden Lackschicht 10 abgedeckt. Im Rahmen des Ausführungsbeispiels ist die Leiterplatte 1 bereits mit dem Speicher 3 und dem Prozessor 2 bestückt dargestellt, wobei der Speicher 3a über seinen Anschluss 6 mit der Leiterbahn 4a und der Prozessor 2 über einen Anschluss 7 mit der Leiterbahn 4a nach dem Verlöten elektrisch verbunden ist. Die Leiterbahn 4a besteht dabei vorzugsweise aus Kupfer. Die Leiterplatte 2 weist dabei eine Vorderseite A und eine Rückseite B auf.

Weiterhin weist, wie schon oben beschrieben, die erfindungsgemäße Leiterplatte 1 die Beschichtung 5a, die aus dem elektromagnetische Strahlungen dämpfende Material besteht, auf. Alternativ oder zusätzlich zur Beschichtung 5a kann die Leiterplatte 1 auch eine Beschichtung 9a aus dem elektromagnetische Strahlungen dämpfenden Material aufweisen, wobei das Material in dem Bereich auf die Oberfläche der Rückseite der Leiterplatte 1 ein- und mehrschichtig aufgedruckt und/oder ein- oder mehrschichtig aufgespritzt ist. Die Beschichtung 9a deckt in dem Bereich 8a die Leiterbahnen ab. Die Beschichtung 5a auf der Vorderseite A der Leiterplatte 1 und die Beschichtung 9a auf der Rückseite der Leiterplatte 1 dämpfen somit wirkungsvoll in dem Bereich 8a auf die Leiterbahnen einwirkende und von den Leiterbahnen ausgehende elektromagnetische Strahlungen. Die Beschichtung 5a und die Beschichtung 9a weisen eine Dicke d auf, wobei der Übersichtlichkeit halber die Dicke d nur bei der Beschichtung 5a dargestellt ist. Die Beschichtung 5a und die Beschichtung 9a können selbstverständlich aber auch unterschiedliche Dicken aufweisen.

In FIG 3 ist in Form einer schematisierten Darstellung ein weiteres Ausführungsbeispiel der Erfindung dargestellt. Die in FIG 3 dargestellte Ausführungsform entspricht im Grundaufbau im Wesentlichen der vorstehend in FIG 2 und FIG 1 beschriebenen Ausführungsform. Gleiche Elemente sind daher in FIG 3 mit den gleichen Bezugszeichen versehen wie in FIG 1 und FIG 2. Der einzige wesentliche Unterschied besteht darin, dass bei der Ausführungsform gemäß FIG 3 die Beschichtung 5a, d.h. das elektromagnetische Strahlungen dämpfende Material, direkt ohne eine zwischengeschaltete Lackschicht in den Bereichen 8a und 8b auf die Leiterbahnen und insbesondere auf die Leiterbahn 4a aufgebracht ist. Das Material weist somit einen direkten mechanischen Kontakt mit den Leiterbahnen auf. Diese Ausführungsform ist möglich, wenn das Material nicht elektrisch leitend ist und ermöglicht eine besonders gute Reduzierung der elektromagnetischen Störstrahlungen.

Im Rahmen der Ausführungsbeispiele gemäß der Figuren 1 bis 3 ist die Leiterplatte 1 nur einschichtig aufgebaut, d.h. sie weist nur eine Leiterbahnschicht 7 auf. Selbstverständlich ist die Erfindung jedoch bei einer Leiterplatte die zwei, drei, vier oder noch mehr Leiterbahnschichten aufweist, anwendbar.

In FIG 4 ist z.B. eine Leiterplatte 1' in Form einer stark schematisierten Ansicht dargestellt, die zusätzlich zur Leiterbahnschicht 7 auf der Vorderseite A auch auf der Rückseite B eine Leiterbahnschicht 7' mit einer Leiterbahn 4a' und einer mit der Leiterbahn 4a' in einem direkt mechanischen Kontakt stehenden erfindungsgemäßen Beschichtung 9a' aus dem elektromagnetische Strahlungen dämpfenden Material, aufweist. Weiterhin weist die Leiterplatte 1' eine schematisiert dargestellte Lackschicht 10' auf. Die Leiterplatte 1' weist somit zwei Leiterbahnenschichten auf, entspricht aber ansonsten bezüglich der Funktionsweise der Erfindung der Ausführungsform gemäß FIG 3, wobei gleiche Elemente in FIG 4 mit den gleichen Bezugszeichen versehen sind wie in FIG 3.

Weiterhin kann auch, wie in FIG 5 dargestellt, die erfindungsgemäße Beschichtung aus dem elektromagnetische Strahlung dämpfenden Material in Form der in FIG 5 dargestellten Beschichtung 5a und 9a' vorliegen, d.h. auf die Lackschicht 10' aufgebracht sein, wobei die jeweilige Beschichtung in diesem Fall nicht unbedingt aus einem elektrisch nicht leitenden Material sein muss. Ansonsten entspricht die Ausführungsform gemäß FIG 5 der Ausführungsform gemäß FIG 4, wobei gleiche Elemente in FIG 5 mit den gleichen Bezugszeichen versehen sind wie in FIG 4.

Wie schon oben beschrieben, ist das Material in den Bereichen 8a und 8b auf die Oberfläche der Leiterplatte erfindungsgemäß ein- oder mehrschichtig aufgedruckt und/oder ein- oder mehrschichtig aufgespritzt. Das Material kann dabei z.B. im Siebdruckverfahren auf die Oberfläche der Leiterplatte ein- oder mehrschichtig aufgebracht werden, wobei durch entsprechende Siebdruckmasken beim Druck nur ganz gezielt die gewünschten Bereiche mit dem Material abgedeckt werden können. Das mehrschichtige Drucken kann dabei z.B. realisiert werden, in dem nach jedem Auftragen des Materials und einem anschließenden Trocknungsprozess, bei dem sich das dämpfende Material verfestigt, das Material wieder erneut aufgedruckt wird und somit mehrere Schichten mit dem dämpfenden Material aufgedruckt werden. Durch Variation der Siebdicken beim Siebdruckverfahren und/oder dem schon beschriebenen mehrschichtigen Aufdrucken des dämpfenden Materials können so gezielt beliebige Dicken des dämpfenden Materials auf der Oberfläche der Leiterplatte aufgebracht werden und somit die gewünschte Dämpfung der elektromagnetischen Strahlungen gezielt gesteuert werden. In Bereichen, in denen starke elektromagnetische Strahlungen auftreten, kann somit das dämpfende Material besonders dick aufgebracht werden und somit eine sehr hohe Dämpfung erzielt werden, während in Bereichen mit z.B. mittlerer elektromagnetischer Strahlungsstärke die Dicke des auf die Oberfläche der Leiterplatte aufgebrachten dämpfenden Materials reduziert werden kann. Es sei an dieser Stelle angemerkt, dass im Rahmen des Ausführungsbeispiels die beiden Beschichtungen 5a und 5b unterschiedliche Dicken aufweisen.

Wenn das dämpfende Material temperaturbeständig ist, d.h. z.B. Temperaturen von mindestens 200°C und insbesondere Temperaturen von mindestens 250°C aushält (z.B. je nach Lötverfahren) können im Allgemeinen alle nach der erfindungsgemäßen Beschichtung nachfolgenden üblichen Fertigungsverfahren zur Fertigung von Baugruppen, insbesondere zur Fertigung von Flachbaugruppen, weiter verwendet werden (z.B. SMD, THT, THT-Reflow, Einpressen etc.).

Weiterhin kann das dämpfende Material aber auch auf die Oberfläche der Leiterplatte, z.B. mittels einer Düse, ein- oder mehrschichtig aufgespritzt werden, wobei das Material z.B. wie eine Farbe oder ein Klebstoff nach dem Aufspritzen jeder Schicht des Materials in einen festen Zustand übergeht indem es austrocknet und/oder aushärtet. Entsprechend der Anzahl der Schichten, kann auch hier die erzielbare Dämpfung der elektromagnetischen Strahlung gezielt gesteuert werden. Das Aufspritzen kann z.B. mit Hilfe eines Plotters erfolgen. Das Aufspritzen und/oder Aufdrucken des dämpfenden Materials ist automatisierbar und somit kostengünstig realisierbar.

Mit Hilfe der Erfindung können die Leiterplatten auch nach deren Herstellung hinsichtlich ihrem EMV-Verhalten und ihrer HF-Robustheit optimiert werden. Weiterhin weist die Erfindung den Vorteil auf, dass einfache Variantenbildungen von Leiterplatten und insbesondere von fertig bestückten Leiterplatten möglich sind, z.B. optimiert für den Einsatz bezüglich elektromagnetischer Strahlung in eher unkritischen oder mehr kritischen Umgebungen. Weiterhin sind mittels der Erfindung, insbesondere bei komplex aufgebauten Leiterplatten und Leiterbahnverlegungen auch sensible elektrische Signale direkt an der Leiterplattenoberseite und/oder an der Leiterplattenunterseite verlegbar. Dies führt zu Einsparpotential bei der Schichtanzahl der Leiterplatte und größerer Gestaltungsfreiheit bei der Entflechtung komplexer Schaltungen, da nicht mehr wie sonst im Allgemeinen üblich die Bedingung gegeben ist, das kritische Signale vorzugsweise in den Zwischenschichten innerhalb der Leiterplatte geführt werden sollten.

Weiterhin weist die Erfindung den Vorteil auf, dass das erfindungsgemäße Aufspritzen und/oder Aufdrucken des dämpfenden Materials bei jeder beliebigen handelsüblichen Leiterplatte, insbesondere auch nach deren Herstellung durchgeführt werden kann.

Das Aufdrucken und/oder Aufspritzen des dämpfenden Materials erfolgt dabei vorzugsweise vor der Bestückung der Leiterplatte mit Bauteilen, kann aber auch bei einer schon mit Bauelementen bestückten Leiterplatte durchgeführt werden und zwar sowohl vor dem Löten der Bauelemente als auch nach dem Löten der Bauelemente auf der Leiterplatte.

## Patentansprüche

1. Leiterplatte, wobei die Leiterplatte (1,1') elektrisch leitende Leiterbahnen aufweist, wobei die Leiterplatte (1,1') in mindestens einem Bereich (8a) der Leiterplatte (1,1') in dem mindestens eine Leiterbahn (4a) verläuft auf der Vorderseite (A) und/oder der Rückseite (B) der Leiterplatte (1,1') eine Beschichtung (5a) aus einem elektromagnetische Strahlungen dämpfenden Material aufweist, wobei das Material in dem Bereich (8a) auf die Oberfläche der Leiterplatte (1,1') ein- oder mehrschichtig aufgedruckt und/oder ein- oder mehrschichtig aufgespritzt ist.

2. Leiterplatte nach einem der vorhergehenden Ansprüche, **dadurch gekennzeichnet, dass** das Material eisenhaltig und/oder ferrithaltig ist.

3. Leiterplatte nach einem der vorhergehenden Ansprüche, **dadurch gekennzeichnet, dass** das Material nicht elektrisch leitend ist.

4. Leiterplatte nach Anspruch 3, **dadurch gekennzeichnet, dass** das Material auf der Vorderseite (A) und/oder der Rückseite (B) der Leiterplatte (1,1') in dem Bereich (8a) einen direkten mechanischen Kontakt mit den Leiterbahnen aufweist.

5. Leiterplatte nach einem der vorhergehenden Ansprüche, **dadurch gekennzeichnet, dass** das Material bis mindestens 200°C temperaturbeständig ist.

6. Leiterplatte nach einem der vorhergehenden Ansprüche, **dadurch gekennzeichnet, dass** die Dicke (d) der Beschichtung (5a) an eine gewünschte Dämpfungshöhe der elektromagnetischen Strahlungen angepasst ist.

7. Verfahren zur Reduzierung von auf eine Leiterbahn (4a) einer Leiterplatte (1,1') einwirkende elektromagnetische Störeinstrahlungen und/oder von einer Leiterbahn (4a) einer Leiterplatte ausgesendete elektromagnetische Störausstrahlungen, wobei auf die Leiterplatte (1,1') in mindestens einem Bereich (8a) der Leiterplatte in dem mindestens eine Leiterbahn (4a) verläuft auf der Vorderseite (A) und/oder der Rückseite (B) der Leiterplatte (1,1') eine Beschichtung (5a) aus einem elektromagnetische Strahlungen dämpfenden Material aufgebracht wird indem das Material in dem Bereich auf die Oberfläche der Leiterplatte (1,1') ein- oder mehrschichtig aufgedruckt und/oder ein- oder mehrschichtig aufgespritzt wird.
